# EUROPEAN PATENT APPLICATION

(11) **EP 3 214 659 A1**
(43) Date of publication of application: **06.09.2017**
(21) Application number: 16158234.1
(22) Date of filing: 02.03.2016
(51) Int. Cl.: H01L 31/048, H02S 40/22, H01L 31/0236, H01L 31/056, H01L 31/054, H01L 31/068

(54) **BI-FACIAL PHOTOVOLTAIC DEVICE COMPRISING A REAR TEXTURE**

(71) Applicant: DSM IP Assets B.V., 6411 TE Heerlen (NL)
(72) Inventor: The designation of the inventor has not yet been filed
(74) Representative: Bootsma, Jan P.C.

(57) **Abstract**

Disclosed is a photovoltaic device comprising a transparent front cover, a rear cover comprising a texture on its largest external surface, the texture comprising a plurality of pyramids, and a bi-facial photovoltaic cell positioned between the transparent front cover and the rear cover. Also disclosed are methods of installing photovoltaic devices. In an embodiment, the pyramids comprise a base angle of from 46.5 to 56 degrees and a base having four sides.

## Description

### Field

The invention relates to photovoltaic devices, their assembly, and their installation.

### Background

It is known that providing a texture on the front, light-receiving external surface of a photovoltaic device may increase the efficiency of the photovoltaic device. The texture may have the effect of providing an anti-reflective and/or light trapping effect, depending on the texture's design and construction.

Both an anti-reflective and a light-trapping effect allow more light to be captured by the photovoltaic cell of the photovoltaic device. The photovoltaic cell of the photovoltaic device is the portion of the photovoltaic device where light can be converted to electricity. An anti-reflective effect reduces the amount of light reflected off of the light-receiving external surface of the photovoltaic device, thereby allowing more light to reach the photovoltaic cell of the photovoltaic device. A light-trapping effect traps light that may be reflected off the cover, photovoltaic cell, back sheet, busbars, or other portions of the photovoltaic device and directs it back toward the photovoltaic cell of the photovoltaic device.

Various designs of textures are known. For instance, a texture in the form of elongated grooves, as in for instance, US8048250, assigned to Genie Lens Technologies. A texture in the form of patterns of individual structures is also known, as in for instance, US4053327, assigned to Communications Satellite Corporation. A texture may comprise structures in the form of three-sided, four-sided, or hexagonal base pyramids. Further alternative textures may comprise n-polygonal structures as known from US8283560 and US20120204953, assigned to DSM IP Assets BV.

A texture is typically formed as a textured sheet. The textured sheet may be in the form of the cover of the photovoltaic device itself, or on a separate sheet that is adhered to a component of the photovoltaic device, such as the cover. The textured sheet may be secured to the photovoltaic device by a separate step or during the lamination step of photovoltaic device assembly.

In the lamination step, a photovoltaic device is formed by bonding together the various components of the photovoltaic device, such as the photovoltaic cell and the cover, with a hot-melt adhesive in a laminator. An elevated temperature (the lamination temperature) is applied in order to cause the hot-melt adhesive to enter a sufficiently flowable state. A pressure is applied to ensure the removal of air bubbles from the hot-melt adhesive. The entire assembly is then cooled, thereby hardening the hot-melt adhesive and securing the components of the photovoltaic device together.

Degradation in certain materials that may be used to form a texture may occur due to the strains placed on the materials from continuous outdoor use for a period of ten, twenty, or more years. The degradation may be caused by heat, humidity, rain, direct sun exposure, mechanical stress, or particulates, such as sand or dust. This degradation can decrease the anti-reflective or light-trapping effects over time or otherwise block light from reaching the photovoltaic cell of the photovoltaic device.

One method to provide a texture is to directly texture a hot-melt adhesive. A hot-melt adhesive is typically used to join elements of a photovoltaic device together. Such a method is disclosed in US6075652, assigned to Washi Kosan Co., Ltd. After the hot-melt adhesive (in this case, ethylene vinyl acetate (EVA)) is textured, the photovoltaic device is dipped in a fluorine-containing resin.

Perhaps due to the durability requirements of a texture on the external surface of photovoltaic devices, most efforts in providing a texture have been directed to texturing known outdoor durable materials. For example, the texture may be formed from glass and certain outdoor durable polymers.

A rolling or etching process may be used to form the texture from glass. An example of a rolling process is disclosed in US8484994, assigned to Saint Gobain Glass France.

One way to make a texture from a polymer is, for example, hot-rolling the texture into a thermoplastic. Such a technique is disclosed in US8048250, assigned to Genie Lens Technologies, LLC. The polymer film can then be applied to the front cover of the photovoltaic device with the aid of a suitable adhesive.

Other processes for providing a texture involve energy-curing. The texture may be formed by curing a liquid energy-curable resin on top of a base film or glass. In such a process, a liquid energy-curable resin is deposited on a base film or glass and brought into contact with a mold. Curing radiation, usually in the form of UV light or electron beam, is supplied while the liquid energy-curable resin is in contact with the mold, thereby hardening the energy-curable resin and forming the desired texture. Examples of such a process are disclosed in US20120024355, assigned to DSM IP Assets BV, and US8048250, assigned to Genie Lens Technologies, LLC.

Although a texture on the front, light-receiving external surface of a photovoltaic device may increase the efficiency of the photovoltaic device, such a texture may have a negative impact on the durability of the photovoltaic device. For example, the material making up the texture is typically less mechanically robust than glass. Additionally, the texture may be more difficult to clean than glass or an anti-reflective coating, exacerbating the negative impact that bird droppings and dirt have on the efficiency of the photovoltaic device. Biofouling may also be more likely for textured surfaces than flat surfaces. Accordingly, a photovoltaic device with high efficiency and improved durability is desirable.

### Summary

A first embodiment is a photovoltaic device comprising: a transparent front cover optionally comprising a texture and/or an anti-reflective coating on its largest external surface; a rear cover comprising a texture on its largest external surface, the texture comprising a plurality of pyramids; and a bi-facial photovoltaic cell comprising a major side and a minor side wherein light entering from the major side is converted to electricity at an efficiency that is greater than the efficiency at which light entering from the minor side is converted to electricity, the bi-facial photovoltaic cell being positioned between the transparent front cover and the rear cover such that the major side faces the transparent front cover and the minor side faces the rear cover.

A second embodiment is a photovoltaic device comprising: a transparent front cover optionally comprising a texture and/or an anti-reflective coating on its largest external surface; a rear cover comprising a texture on its largest external surface, the texture comprising a plurality of pyramids; and a bi-facial photovoltaic cell positioned between the transparent front cover and the rear cover; wherein the photovoltaic device is fixed in a position such that the transparent front cover receives more direct sunlight than the rear cover.

In an embodiment, the pyramids in the first or second embodiment comprise a base angle of from 46.5 to 56 degrees and a base having four sides. In an embodiment, the pyramids in the first or second embodiment comprise at least two base angles of from 46.5 to 56 degrees and a base having four sides

A second embodiment is a method of installing a photovoltaic device comprising the step of fixing the photovoltaic device of the first or second embodiment in a position such that the transparent front cover receives more direct sunlight than the rear cover. In further embodiments, the photovoltaic device is positioned such that the rear cover receives no direct sunlight.

Photovoltaic devices according to the invention may have improved efficiency over the bi-facial photovoltaic devices of the prior art. Additionally, the photovoltaic devices may have improved durability over the photovoltaic devices of the prior art because at least the texture on the largest external surface of the rear cover is not exposed to the environment in the same way that a texture on the largest external surface of the transparent front cover may be.

### Brief Description of the Drawings

Fig. 1 is a schematic representation of a portion of an embodiment of a photovoltaic device according to the invention.
Fig. 2 is a schematic representation of a computer model of a photovoltaic cell associated with Example 1.
Fig. 3 is a plot of relative improvement in quantum efficiency over a baseline vs. base angle of a pyramid associated with Example 1.
Fig. 4 is a table of relative improvement in quantum efficiency over a baseline vs. base angle of a pyramid associated with Example 2.

### Detailed Description

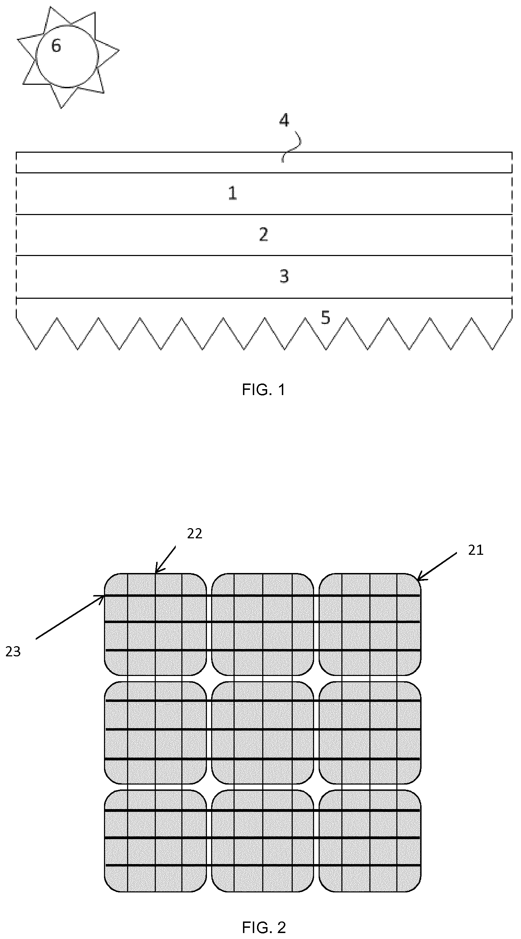

FIG. 1 depicts a portion of an embodiment of a photovoltaic device. The portion of the photovoltaic device comprises a transparent front cover 1, a bi-facial photovoltaic cell 2, and a rear cover 3. Additional layers, such as encapsulants or electrodes, for example transparent conductive electrodes, may be present between the transparent front cover and rear cover, but are not depicted in FIG. 1. The photovoltaic device is typically integrally formed, via bonding together the transparent front cover, the rear cover, and the bi-facial photovoltaic cell with the aid of a suitable encapsulant.

The transparent front cover 1 and rear cover 3 may be formed from any suitable transparent material, such as a glass or a polymer. Although not essential for the invention, the transparent front cover depicted in FIG. 1 comprises an anti-reflective coating 4 on the transparent front cover's largest external surface. By largest external surface it is meant the external surface possessing the largest surface area. For a standard photovoltaic module, the largest external surface is the front surface that will be positioned to face the sun. Anti-reflective coatings are common in the art of photovoltaic devices. An example of a commercially available anti-reflective coating is DSM MP Coat AR.

The photovoltaic device comprises a bi-facial photovoltaic cell 2. Bi-facial photovoltaic cells, also known as double-sided photovoltaic cells, are known in the art. Bi-facial photovoltaic cells are capable of converting light coming from either side of the photovoltaic cell into electricity. Light entering from either side of a bi-facial photovoltaic cell is typically not converted to electricity at the same efficiency. Rather, bi-facial photovoltaic cells typically possess a major and a minor side. Light entering through the major side is converted to electricity at an efficiency that is greater than the efficiency at which light entering from the minor side is converted to electricity. Consequently, the bi-facial photovoltaic cell should be positioned such that the major side is the front side of the photovoltaic device and thus receives the maximum amount of direct sunlight.

The rear cover 3 comprises a texture 5 on its largest external surface. Preferably, rear cover 3 is transparent. The texture 5 may contain, for example, repetitions of the same structure in the same orientation, repetitions of the same structure in different orientations, a repeated pattern of different structures, or different structures in a random pattern and/or orientation. The texture 5 comprises a plurality of pyramids. In an embodiment, the texture 5 comprises a repeating pattern of pyramids. Pyramids comprise a base and an apex connected by a plurality of sides. The number of sides of a pyramid is equal to the number of sides of its base. The base angle of the pyramid is the angle between the base and a side. A pyramid may have more than one different base angle.. In an embodiment, the pyramids comprise a base angle of from 46.5 to 56 degrees and a base having four sides. In an embodiment, the pyramids comprise a base angle of from 48 to 56 degrees and a base having four sides. In an embodiment, the pyramids comprise a base angle of from 49 to 56 degrees and a base having four sides. In an embodiment, the pyramids comprise a base angle of from 50 to 56 degrees and a base having four sides. In an embodiment, the pyramids comprise a base angle of from 49 to 53 degrees and a base having four sides. In an embodiment, the pyramids comprise a base angle of from 50 to 53 degrees and a base having four sides. In an embodiment, the pyramids comprise a base angle of from 50.5 to 52.5 degrees and a base having four sides. In an embodiment, all base angles of the pyramid are equal. In an embodiment, the pyramid has at least two base angles that are equal.

In an embodiment, the pyramid is a square-base pyramid, meaning the pyramid's base has four sides of substantially equal length. In an embodiment, the pyramid has a rectangular base. The pyramid may also have an apex that meets at a point, is curved, or is a plane. The sides of the pyramid may thus be, for example, triangles or trapezoids. The pyramids may be regular pyramids, such that the apex is centered above the base, or they may be skewed, such that the center of the apex is not centered above the base.

In an embodiment, the height of the pyramids is from 1 to 500 µm, as measured from base to apex. In an embodiment, the height of the pyramids is from 10 to 150 µm. In an embodiment, the height of the pyramids is from 20 to 100 µm.

In an embodiment, the largest external surface of the transparent front cover 3 comprises a texture. A texture may be a repeating pattern or random. Non-limiting examples of textures are arrays comprising a plurality of structures in the form of three-sided, four-sided, or hexagonal base pyramids, or n-polygonal structures as in US8283560 and US20120204953 assigned to DSM IP Assets BV. In an embodiment, the largest external surface of the transparent front cover comprises an anti-reflective coating.

In an embodiment, a texture is defined as having a repeating pattern or a 3D root mean square roughness (Sq) of 0.1 micrometers or greater. In an embodiment, a texture is defined as having a repeating pattern or a Sq of 0.2 micrometers or greater. In an embodiment, a texture is defined as having a repeating pattern or a Sq of 0.5 micrometers or greater. In an embodiment, a texture is defined as having a repeating pattern or a Sq of 1.0 micrometers or greater. In an embodiment, a texture is defined as having a repeating pattern or a Sq of 5.0 micrometers or greater.

In an embodiment, a texture is defined as having a repeating pattern or a Sq of 0.1 micrometers or greater and a kurtosis (Sₖᵤ) of 2.5 or greater. In an embodiment, a texture is defined as having a repeating pattern or a Sq of 0.2 micrometers or greater and a Sₖᵤ of 2.5 or greater. In an embodiment, a texture is defined as having a repeating pattern or an Sq of 0.5 micrometers or greater and a Sₖᵤ of 2.5 or greater. In an embodiment, a texture is defined as having a repeating pattern or a Sq of 1.0 micrometers or greater and a Sₖᵤ of 2.5 or greater. In an embodiment, a texture is defined as having a repeating pattern or a Sq of 5.0 micrometers or greater and a Sₖᵤ of 2.5 or greater.

In an embodiment, a texture is defined as having a repeating pattern, or a Sq of 0.1 micrometers or greater and a Sₖᵤ of 3.0 or greater. In an embodiment, a texture is defined as having a repeating pattern, or a Sq of 0.2 micrometers or greater and a Sₖᵤ of 3.0 or greater. In an embodiment, a texture is defined as having a repeating pattern, or a Sq of 0.5 micrometers or greater and a Sₖᵤ of 3.0 or greater. In an embodiment, a texture is defined as having a repeating pattern, or a Sq of 1.0 micrometers or greater and a Sₖᵤ of 3.0 or greater. In an embodiment, a texture is defined as having a repeating pattern, or a Sq of 5.0 micrometers or greater and a Sₖᵤ of 3.0 or greater.

In an embodiment, the largest external surface of the transparent front cover is substantially devoid of a texture. In an embodiment, the largest external surface of the transparent front cover is substantially devoid of a texture and comprises an anti-reflective coating.

All surface parameters are determined under ISO 25178-2:2012. All parameters are measured on the external-most surface. For example, in the case that an anti-reflective coating is present on glass, the measurements are taken on the external surface of the anti-reflective coating.

A texture may be formed directly on the transparent cover or applied as a film and adhered to the transparent cover. In the case of a texture formed directly on the transparent cover, a primer or a surface treatment, such as a plasma surface treatment, may be necessary to obtain adequate adhesion of the texture to the transparent cover. In the case the texture is applied as a film, the film may include an adhesive, such as a pressure sensitive adhesive or hot-melt adhesive, so that the film can be adequately secured to the transparent cover. A primer layer may be necessary to obtain adequate adhesion of the texture to the base film or adhesive.

The texture may be formed from a thermoset material, such as by curing an energy-curable resin in the shape of a texture as in a known UV embossing process, or is formed from a thermoplastic material, such as in a known thermal embossing process. Most energy-cured textures having geometry that is converging over all surfaces to an apex, such as a point apex or a plane apex, can be made in such a process. Preferably, the structures making up the texture are converging over all surfaces.

As depicted in FIG. 1, the photovoltaic device is positioned so that the rear cover receives no direct sunlight from sun 6 and the transparent front cover receives more direct sunlight from sun 6 than the rear cover. In an embodiment, the photovoltaic device is fixed in such a position, such as by fastening the photovoltaic device to a support structure with the aid of screws, bolts, etc. Direct sunlight is when the sun shines directly on an object. Sunlight deflected by a mirror or other reflector is not direct sunlight.

### Examples

### Example 1 - Simulation of a rear texture of square-base pyramids with normal incident light

A computer model of a bi-facial cell is created in TracePro software. A schematic of the computer model is depicted in Fig. 2. The module consists of nine individual photovoltaic cells 21 in a 3x3 arrangement. Each cell is a 156 mm by 156 mm square cut of a 200 mm diameter ingot, leaving the cell with rounded edges. There is a 2 mm gap between cells. Three busbars 22, each having a thickness of 1.5 mm and a height of 50 µm, are evenly spaced on each cell. Light coming into contact with the busbars will be specularly reflected. Each cell has three 2.0 mm wide and 50 µm high finger electrodes 23 running perpendicular to the busbars 22. Light coming into contact with the finger electrodes will be diffusely reflected (Lambertian reflectance). To calculate the reflectivity of the finger electrodes a random, upright pyramid texture having a base angle of 54.74 degrees was assumed using PVLighthouse Opal 2 calculator. The busbars and finger electrodes are present on both sides of the photovoltaic cell. The busbars and finger electrodes are made of silver. The refractive index (n) at 650 nm is 0.14 and the extinction coefficient (k) at 650 nm is 4.15.

The module stack consists of a 200 µm thick textured bi-facial crystalline silicon photovoltaic cell (n at 650 nm is 3.84; k at 650 nm is 1.44x10⁻²), sandwiched between layers of 0.4 mm of EVA encapsulant (n at 650 nm is 1.489; k at 650 nm is 1.92x10⁻⁷) and 2.0 mm thick low-iron glass (n at 650 nm is 1.507; k at 650 nm is 9.61x10⁻⁸) on each side. Each bi-facial photovoltaic cell has on each side a texture of square-base pyramids having a base angle of 54.74° at a spacing of 5 µm. The bi-facial photovoltaic cell is also coated on both sides with a 75 nm thick SiNx anti-reflective coating (n at 650 nm is 1.99; k at 650 nm is 1.00x10⁻⁹). An anti-reflective coating (n at 650 nm is 1.294; k at 650 nm is 0.00) is present on the external cover of the glass that receives direct sunlight.

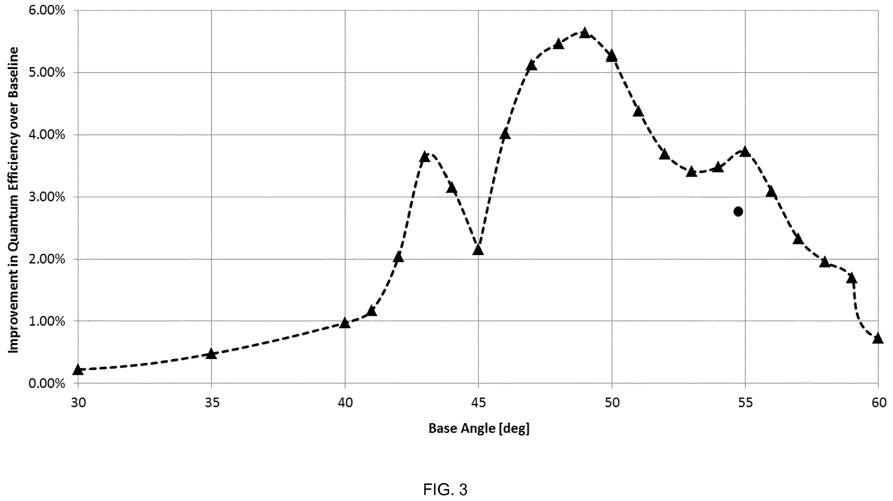

On the rear external cover of the module a texture of repeating square-base pyramids is present. The simulated material of the pyramids is PMMA (n at 650 nm is 1.483; k at 650 nm is 8.66x10⁻⁹). The pyramids have a square base of 30 µm x 30 µm. The rear side of the module receives no direct sunlight. The pyramids are present on a base layer of PMMA that is present between the base of the pyramids and the surface of the rear external cover. The height from the surface of the rear external cover to apex of the pyramids is fixed at 40 µm. The base angle of the pyramid is varied for each simulation, such that the height of the base layer is reduced as the base angle is increased. The simulation is run for base angles of 30, 35, 40, 41, 42, 43, 44, 45, 46, 47, 48, 49, 50, 51, 52, 53, 54, 55, 56, 57, 58, 59 and 60 degrees. A texture of repeating n-polygonal structures corresponding to Figure 3a of US8283560 having a height of 30 µm from base to apex and base angles of 54.74 degrees is also modeled. The height from the surface of the rear external cover to apex of the n-polygonal structure is 40 µm. As a baseline, a module having an anti-reflective coating on both the largest front and rear external surfaces is measured.

A light source is positioned normal to the front surface of the photovoltaic device. Although simulations of normal incident light are not as representative of actual outdoor performance as a simulation that encompasses all angles of incidence at a given location and dependent on weather conditions throughout the year, simulations of normal incident light are still useful because they predict performance in a flash test. A flash test is the standard method of determining the efficiency of a photovoltaic device. A flash test involves directing flashes of normal incident light at the photovoltaic device and recording the performance of the photovoltaic device. These flash tests are typically performed at standard test conditions, characterized by an irradiance of 1000 W/m², an AM1.5g spectrum, and a cell temperature of 25 °C.

The simulated bi-facial photovoltaic cell absorbs photons entering from its front side at a rate that is equal to the rate at which it absorbs photons entering from its rear side. It is expected that overall texture benefit will decrease as the rate at which the bi-facial photovoltaic cell absorbs photons entering from its front side becomes greater than the rate at which the bi-facial photovoltaic cell absorbs photons entering from its rear side. However, the ratio of the benefits of different textures is expected to remain mostly constant.

Only the performance of the middle cell of the 3x3 arrangement is recorded. The light source comprises wavelengths from 300 to 1100 nm in 10 nm steps. The number of photons at each wavelength is weighted according to the AM1.5g sun spectrum. The temperature is 25 °C. The intensity is 1000 W/m² at normal incidence. The quantum efficiency is defined as the ratio of the absorbed number of photons in the middle cell over the incident photon flux (as defined at the source) times the cell area.

A simulation is run for each texture and the quantum efficiency recorded. The quantum efficiency is a relative indicator of photovoltaic module performance. The data is reported as a percentage improvement in quantum efficiency over the baseline module having an anti-reflective coating on both the largest front and rear external surface.

The results are shown in Figure 3. The x-axis is the base angle of the structure and the y-axis is the percentage improvement in quantum efficiency over the baseline. The n-polygonal structure having a base angle of 54.74 degrees is represented as a circle. The data from the square-base pyramid textures is represented by triangles. A surprising increase in module efficiency is apparent, particularly at a base angle of from about 46.5 to 51.5 degrees.

### Example 2 - Simulation of a rear texture of square-base pyramids with weighted incidence distributions

Example 2 utilizes the same experimental setup as Example 1, except that instead of normal incident light a weighted incidence distribution is used. The weighted incidence distribution includes both diffuse and direct light using data from PVsyst. For the direct light, by weighted incidence distribution it is meant that each angle of incidence created by the sun over the course of one year at a given location in the sky is weighted by the amount of time that the sun is present at that location. Diffuse light is assumed to be of equal intensity from all angles around the photovoltaic device. Thus, Example 2 is more indicative of real outdoor performance, whereas Example 1 is more indicative of the flash test that often informs the power rating of a module (Wp).

Four locations were simulated: Maastricht, Netherlands, Sapporo, Japan, Lanzhou, China, and Shanghai, China. The quantum efficiency for the square base pyramid having the specified base angle is reported as a percentage improvement in quantum efficiency over a baseline module having an anti-reflective coating on both the largest front external surface and largest rear external surface (vs ARC), and over a baseline module having an anti-reflective coating on the largest front external surface and a texture having a repeating n-polygonal structure corresponding to Figure 3a of US8283560 having a height of 30 µm and base angles of 54.74 degrees at its largest rear surface (vs CC).

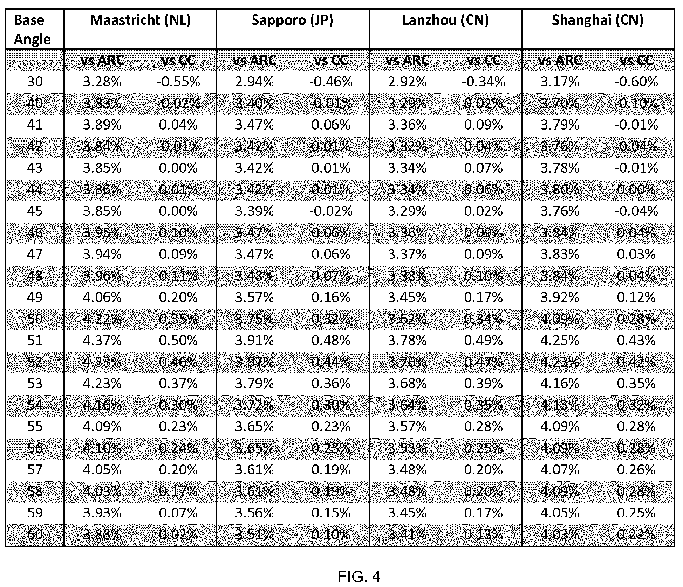

Results are shown in the Table present in Fig. 4. A surprising increase in module efficiency is apparent, particularly at a base angle of from about 49 to 56 degrees.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. While certain optional features are described as embodiments of the invention, the description is meant to encompass and specifically disclose all combinations of these embodiments unless specifically indicated otherwise or physically impossible.

## Claims

1. A photovoltaic device comprising:
a. a transparent front cover optionally comprising a texture and/or an anti-reflective coating on its largest external surface,
b. a rear cover comprising a texture on its largest external surface, the texture comprising a plurality of pyramids, and
c. a bi-facial photovoltaic cell comprising a major side and a minor side wherein light entering from the major side is converted to electricity at an efficiency that is greater than the efficiency at which light entering from the minor side is converted to electricity, the bi-facial photovoltaic cell being positioned between the transparent front cover and the rear cover such that the major side faces the transparent front cover and the minor side faces the rear cover.

2. A photovoltaic device comprising:
a. a transparent front cover optionally comprising a texture and/or an anti-reflective coating on its largest external surface,
b. a rear cover comprising a texture on its largest external surface, the texture comprising a plurality of pyramids, and
c. a bi-facial photovoltaic cell positioned between the transparent front cover and the rear cover,
wherein the photovoltaic device is fixed in a position such that the transparent front cover receives more direct sunlight than the rear cover.

3. The photovoltaic device according to claim 1 or 2, wherein the pyramids comprise a base having four sides.

4. The photovoltaic device according to claim 3, wherein the pyramids comprise a base angle of from 46.5 to 56 degrees.

5. The photovoltaic device according to claim 3, wherein the pyramids comprise a base angle of from 48 to 56 degrees, more preferably from 49 to 56 degrees, more preferably from 50 to 56 degrees, more preferably from 49 to 53 degrees, more preferably from 50 to 53 degrees.

6. The photovoltaic device according to claim 4 or 5, wherein the pyramids comprise at least two equal base angles.

7. The photovoltaic device according to any one of claims 1 to 6, wherein the pyramids comprise a square base.

8. The photovoltaic device according to any one of claims 1 to 7, wherein the texture is a repeating pattern of pyramids.

9. The photovoltaic device according to any one of claims 1 to 8, wherein the transparent front cover is substantially devoid of a texture and optionally comprises an anti-reflective coating.

10. The photovoltaic device according to any one of claims 1 to 9, wherein the largest external surface of the transparent front cover does not have a repeating pattern and has a Sq of less than 5.0 micrometers.

11. The photovoltaic device according to any one of claims 1 to 10, wherein the largest external surface of the transparent front cover does not have a repeating pattern and has a Sq of less than 1.0 micrometers, preferably less than 0.5 micrometers, preferably less than 0.2 micrometers, preferably less than 0.1 micrometers.

12. The photovoltaic device according to any one of claims 1 to 11, wherein the transparent front cover has a Sₖᵤ of less than 2.5.

13. The photovoltaic device according to any one of claims 1 to 12, wherein the photovoltaic device is fixed in a position such that the rear cover receives no direct sunlight.

14. A method of installing a photovoltaic device comprising the step of:
fixing the photovoltaic device according to any one of claims 1 to 13 in a position such that that the transparent front cover receives more direct sunlight than the rear cover.

15. The method of claim 14, wherein the photovoltaic device is positioned such that the rear cover receives no direct sunlight.
